# EUROPEAN PATENT APPLICATION

(11) **EP 1 387 402 A2**
(43) Date of publication of application: **04.02.2004**
(21) Application number: 03102098.5
(22) Date of filing: 10.07.2003
(51) Int. Cl.: H01L 23/485

(54) **Wafer-level method for fine-pitch, high aspect ratio chip interconnect**

(30) Priority: 15.07.2002 US 195273
(71) Applicant: Texas Instruments Incorporated, Dallas, Texas 75251 (US)
(72) Inventor: Arbuthnot, Diane, 75093, Plano (US); Emmett, Jeff R., 75040, Garland (US); Amador, Gonzalo, 75230, Dallas (US)
(74) Representative: Holt, Michael

(57) **Abstract**

A metal structure 300 for an integrated circuit having a plurality of contact pads and a patterned metallization 301 protected by an overcoat layer 303,306. The structure comprises a plurality of windows in the overcoat, selectively exposing the chip metallization, wherein the windows are spaced apart by less than 150 µm center to center. A metal column 308 is positioned on each of the windows; the preferred metal is copper; the column has a height-to-width aspect ratio larger than 1.25 and an upper surface wettable by re-flowable metal. The preferred column height-to-width aspect ratio is between 2.0 and 4.0, operable to absorb thermomechanical stress. A cap of a re-flowable metal 309 is positioned on each of the columns. The metal structure is used for attaching the IC chip to an external part 311.

## Description

### FIELD OF THE INVENTION

The present invention is related in general to the field of semiconductor devices and processes and more specifically to the wafer-level fabrication of fine-pitch, high aspect ratio solder interconnections.

### BACKGROUND OF THE INVENTION

The structure of contact pad metallizations and solder bumps for connecting integrated circuit (IC) chips to semiconductor packages or outside parts, as well as the thermomechanical stresses and reliability risks involved, have been described in a series of detailed publications by the International Business Machines Corporation in 1969 (IBM J. Res. Develop., Vol. 13, pp. 226 - 296): P. A. Totta et al., SLT Device Metallurgy and its Monolithic Extension, L. F. Miller, Controlled Collapse Reflow Chip Joining, L.S. Goldmann, Geometric Optimization of Controlled Collapse Interconnections, K. C. Norris et al., Reliability of Controlled Collapse Interconnections, S. Oktay, Parametric Study of Temperature Profiles in Chips Joined by Controlled Collapse Techniques, B. S. Berry et al., Studies of the SLT Chip Terminal Metallurgy.

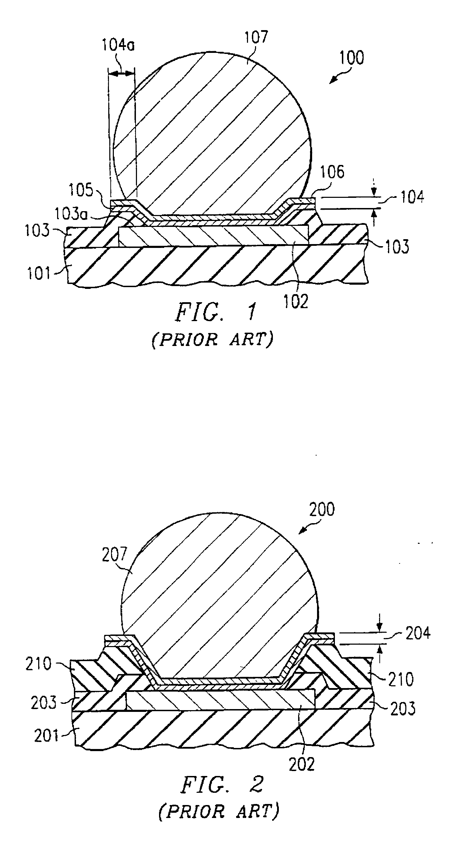

Based on these publications, FIG. 1 illustrates schematically an example of the metallurgical requirements for a contact pad of a small portion of an IC chip generally designated 100. A semiconductor material 101, typically silicon, has patterned aluminum metallization 102 and is protected by a dielectric, moisture-impermeable protective overcoat 103, usually silicon nitride or oxynitride. A window has been opened in the overcoat 103 to expose metallization 102 and leave a protective perimeter 103a around metallization 102. An additional "under bump" metallization 104 has been deposited onto metallization 102 and patterned so that it overlaps by a distance 104a over the overcoat 103. This additional metallization 104 usually consists of a sequence of thin layers. The bottom layer is typically a refractory metal 105, such as chromium, titanium, or tungsten, which provides an ohmic contact to aluminum 102 and a moisture-impenetrable interface to overcoat 103. The top metal 106 has to be solderable; examples are gold, copper, nickel, or palladium. Finally, solder material is deposited, commonly by evaporation, plating or screen-printing, and reflown to form bump 107. These solder bumps assume various shapes (examples are semi-spheres, domes and truncated balls) after the reflow process, influenced by the forces of surface tension during the reflow process; the height/width aspect ratio is < 1.0.

During and after assembly of the IC chip to an outside part such as a substrate or circuit board by solder reflow, and then during device operation, significant temperature differences and temperature cycles appear between semiconductor chip 100 and the substrate. The reliability of the solder joint is strongly influenced by the coefficients of thermal expansion of the semiconductor material and the substrate material. For example, there is more than one order of magnitude difference between the coefficients of thermal expansion of silicon and FR-4. This difference causes thermomechanical stresses, which the solder joints have to absorb. Detailed calculations, in the literature cited above and in other publications of the early 1980's (for instance, C.G.M. van Kessel et al., "The Quality of Die Attachment and its Relationship to Stresses and Vertical Die-Cracking", IEEE 1983; E. Suhir, "Calculated Thermally Induced Stresses in Adhesively Bonded and Soldered Assemblies, ISHM Int. Symp. Microel., Oct 1886; "Die Attachment Design and its Influence on Thermal Stresses in the Die and the Attachment", IEEE 1987) involving the optimum height and volume of the solder connection and the expected onset of fatigue and cracking proposed a number of solder design solutions. It was found for solder that an aspect ratio > 1.0 reduces thermomechanical stresses and postpones cracking of joints.

One commonly practiced method aims at absorbing part of the thermomechanical stress on the solder joints by plastic material surrounding the joints and filling the gap between chip and substrate. See for instance, U. S. Patents # 6,228,680, issued on May 8, 2001; # 6,213,347, issued on Apr. 10, 2001, and # 6,245,583, issued on Jun. 12, 2001 (Thomas et al., Low Stress Method and Apparatus for Underfilling Flip-Chip Electronic Devices). However, the underfilling method represents an unwelcome process step after device attachment to the motherboard.

Another method applies a polymer layer on top of the protective overcoat with the aim of reducing the stress to the overcoat perimeter and the dielectric material underlying the contact pad. See for instance the publication "A Silicon and Aluminum Dynamic Memory Technology" by Richard A. Larsen (IBM J. Res. Develop., vol. 24, May 1980, pp. 268-282). The article includes description of a flip-chip packaging technology using a solder bump on an under-bump metallization, which is resting its perimeter on a thick polyimide layer. The bump structure is often supported by another polyimide layer.

FIG. 2 illustrates schematically an example of a contact pad, generally designated 200, including a polymer overcoat. A silicon chip 201 has patterned aluminum metallization 202 and is protected by a moisture-impermeable inorganic overcoat 203 (silicon nitride) and a polymeric layer 210 (benzocyclobutene or polyimide). A window has been opened through both overcoats. Layers of under-bump metallization 204 establishes contact to the aluminum, adhesion to both overcoats, and solderability to the solder bump 207.

In high-speed, low electromigration IC's, aluminum has been replaced by copper as chip metallization. Due to bondability and contact resistance issues of copper oxide, it is problematic to establish reliable contact to solder material. Approaches based on adding an interface layer of aluminum or of metals with higher affinity to oxygen than copper are costly and not very effective. On the other hand, a method has been described to fabricate a copper layer followed by solder balls onto copper-metallized pads (U.S. Patent Application 10/086,117, filed 02/26/02, Bojkov et al., "Wafer-level Method for Direct Bumping an Copper Pads in Integrated Circuits"). An urgent need has therefore arisen for a coherent, low-cost method of flip-chip assembly of semiconductor devices offering a fundamental solution of metal contact to copper and of thermomechanical stress reliability. The method should be flexible enough to be applied for different semiconductor product families and a wide spectrum of design and process variations. Preferably, these innovations should be accomplished using the installed equipment base so that no investment in new manufacturing machines is needed.

### SUMMARY OF THE INVENTION

The invention describes a metal structure for an integrated circuit having a plurality of contact pads and a patterned metallization protected by an overcoat layer. The structure comprises a plurality of windows in the overcoat, selectively exposing the chip metallization, wherein the windows are spaced apart by less than 150 µm center to center. A metal column is positioned on each of the windows; the preferred metal is copper; the column has a height-to-width aspect ratio larger than 1.25 and an upper surface wettable by re-flowable metal. The preferred column height-to-width aspect ratio is between 2.0 and 4.0, operable to absorb thermomechanical stress. A cap of a re-flowable metal is positioned on each of the columns.

The present invention is related to high density and high speed ICs with copper interconnecting metallization, especially those having high numbers of metallized inputs/outputs for flip-chip assembly. These circuits can be found in many device families such as processors, digital and analog devices, logic devices, high frequency and high power devices, and in both large and small area chip categories.

It is an aspect of the present invention to be applicable to contact pad area reduction and fine-pitch interconnect, and thus supports the shrinking of IC chips. Consequently, the invention helps to alleviate the space constraint of continually shrinking applications such as cellular communication, pagers, hard disk drives, laptop computers and other portable electronic devices.

Another aspect of the invention is to fabricate contact pad copper columns directly on the IC copper metallization without any intermediate barrier layer, so that the resulting minimum electrical resistance enhances the high speed performance of the IC.

Another aspect of the invention is the flexibility to deposit the copper columns in windows of thick photoresist (preferably a Novolak resin) by electroplating the copper column onto the copper metallization or onto a metal layer suitable to receive a plated coating, thereby enabling an electroplating process for depositing the copper columns, providing small pitch center-to-center columns.

Another aspect of the invention is to advance the reliability of chip assemblies by selecting column height-to-width aspect ratios for optimum thermomechanical stress absorption.

Another object of the invention is to provide design and process concepts which are flexible so that they can be applied to many families of semiconductor products, and are general so that they can be applied to several generations of products.

Another object of the invention is to use only designs and processes most commonly employed and accepted in the fabrication of IC devices, thus avoiding the cost of new capital investment and using the installed fabrication equipment base.

These objects have been achieved by the teachings of the invention concerning selection criteria and process flows suitable for mass production. Various modifications have been successfully employed to satisfy different selections of materials and plating technologies.

In the first embodiment of the invention, the whole surface of the metal column is wettable; consequently the whole column surface is covered by a film of the cap metal after completion of the cap reflow process, preventing any oxidation of the column metal.

In the second embodiment of the invention, the metal column is not wettable and an additional wettable metal layer is needed on the upper surface of the column for reliable attachment of the reflow metal. Consequently, the reflowed metal remains exclusively on the upper surface of the column after the cap reflow process.

The preferred method of fabricating the connecting columns is electro-plating. A photoresist layer, preferably a Novolak resin, is applied having a thickness comparable to the intended height of the column. A plurality of windows are then opened in this photoresist layer and the columns are electro-plated in these windows. The preferred column metal includes copper, nickel, gold, and copper alloy.

The technical advances represented by the invention, as well as the aspects thereof, will become apparent from the following description of the preferred embodiments of the invention, when considered in conjunction with the accompanying drawings and the novel features set forth in the appended claims.

### BRIEF DESCRIPTION OF THE DRAWINGS

FIG. 1 is a schematic cross section of a solder bump and undermetal layer for flip-chip assembly, as fabricated by known technology;
FIG. 2 is a schematic cross section of a solder bump and undermetal arrangement over the chip contact pad metallization for flip-chip application according to known technology;
FIG. 3 is a schematic cross section of a high aspect ratio interconnection column with reflowable cap, fabricated by electroplating according to the invention, attached to an external part;
FIG. 4A is a schematic perspective view of a plurality of high aspect ratio interconnection columns, fabricated on fine pitch IC chip contact pads according to the invention;
FIG. 4B is a schematic top view of the interconnection columns of FIG. 4A to demonstrate the fine pitch center-to-center spacing of the columns;
FIGS. 5 to 11 are schematic cross sections of a chip contact, indicating the major process steps for fabricating a column-shaped interconnection suitable for attachment to external parts; and
FIG. 12 is a block diagram of the process flow for fabricating wafer-level fine-pitch high aspect ratio chip interconnects.

### DETAILED DESCRIPTION OF THE PREFERRED EMBODIMENTS

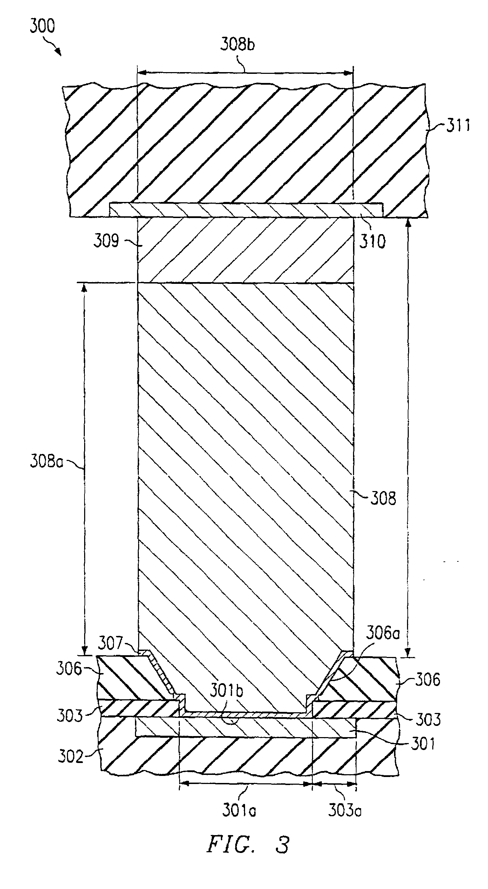

FIG. 3 illustrates schematically the cross section of a metallic interconnection, generally designated 300, between a contact pad of an integrated circuit (IC) chip and a terminal pad of an external part, such as a printed circuit board. The example of the interconnection shown exhibits the high aspect ratio provided by the fabrication method of the present invention.

The top metallization, the patterned layer 301 of the IC, is located over insulating material 302 and protected by inorganic overcoat 303 and polymeric overcoat 306. Patterned metallization 301 is selected from a group consisting of aluminum, aluminum alloy, copper, and copper alloy. The inorganic overcoat 303 consists preferably of moisture-impermeable silicon nitride, silicon oxynitride, silicon carbide, or multi-layers thereof, preferably in the thickness range from 0.2 to 2.5 µm. The organic overcoat 306 consists preferably of polyimide, benzocyclobutene or related materials, preferably in the thickness range from 2.0 to 8.0 µm. Overcoat 303 overlaps the metallization 301 by a length 303a. The prime function of the organic material 306 is to help absorb thermomechanical stress after completion of the device assembly on external parts. Overcoat 303 and especially the thicker overcoat 306 exhibit a slope 306a towards metallization layer 301, brought about by the etching of the overcoats during the window opening process for exposing metallization 301.

If the metallization 301 is copper, the surface 301b of the exposed copper is carefully cleaned after opening the window 301a; see the process detail below. The "under-bump metal" 307 is then also copper. The interface of copper 301 to the copper layer 307 contributes no measurable electrical resistance to the resistance of contact pad 300. If the metallization 301 is aluminum or an aluminum alloy, under-bump metal 307 is commonly made of one or more metal layers selected from titanium, tungsten, tantalum, nickel, vanadium, or other refractory metals. The preferred thickness range of the under-bump metal layer 307 is 0.1 to 2.0 µm. As described below, after the plating process for the tall column, under-bump metal layer 307 is patterned; it has then the configuration to overlay metallization surface 301b and overcoat slope 306a, as indicated in FIG. 3.

On the under-bump metal layer 307 is plated metal column 308. This metal is elected from a group consisting of copper, gold, silver, nickel, palladium, and alloys thereof. Examples of alloys include copper/nickel alloy, preferably having 69 to 89 weight% copper, and silver/ copper alloy, preferably having 28.1 weight% copper. The metal for column 308 is selected to give column 308 a stiffness suitable for absorbing thermomechanical stress, which arises in the interconnection 300 during temperature cycles, when the semiconductor chip and the external part have different coefficients of thermal expansion. (As defined herein, in the elastic stress/strain regime, "stiff" is used for high ratios, and "compliant" for low ratios).

It is pivotally important for the present invention that column 308 has a height-to-width aspect ratio between 1.25 and 5.0, preferably between 2.0 to 4.0. In FIG. 3, the column height, as measured from the surface of the overcoat 306, is marked 308a, and the column width 308b. With the aspect ratio height/width in the range 2.0 to 4.0, column 308 is optimally operable to absorb thermomechanical stress.

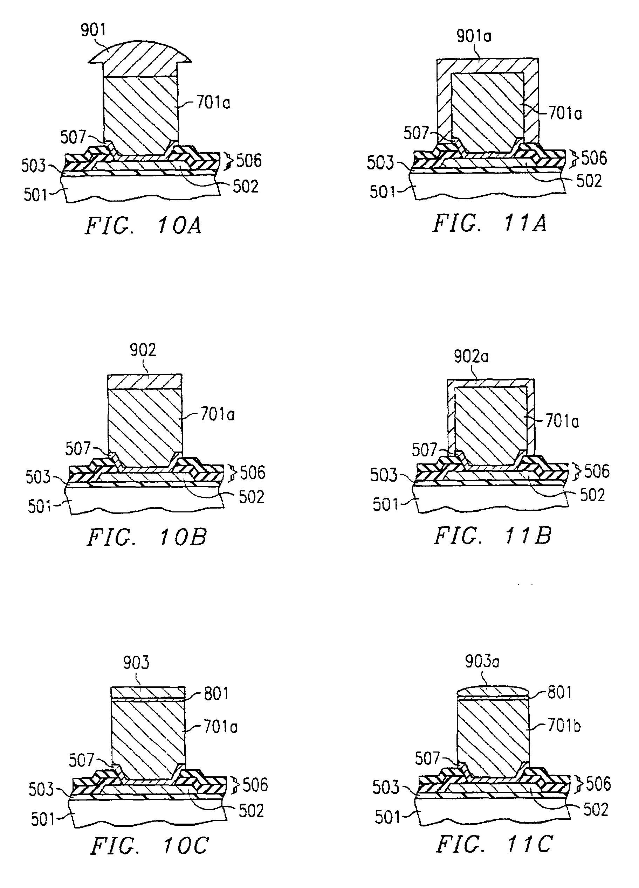

Since the metals used in column 308 do not melt in the typical assembly temperature ranges, an additional layer 309 is needed, made of a metal or metal alloy capable of reflowing. The outlines of layer 309 in FIG. 3 are only schematic; more realistic embodiments are shown in FIGs. 10A, 10B, 10C, and 11A and 11B. The metal for layer 309 is selected from a group consisting of tin, indium, tin alloys including tin/indium, tin/silver, tin/bismuth, and tin/ lead; other choices include conductive adhesives and z-axis conductive materials. The preferred deposition method for metals is plating. Layer 309 as a cap on column 308, has a preferred thickness in the range from 1.0 to 25.0 µm.

As indicated in FIG. 3, the reflowable metal 309 is attached to the terminal pad 310 of the external part 311. Commonly, part 311 is a printed wiring board, a ceramic substrate, or a flexible polymer substrate. Terminal pad 310 is typically made of copper, often with a gold flash.

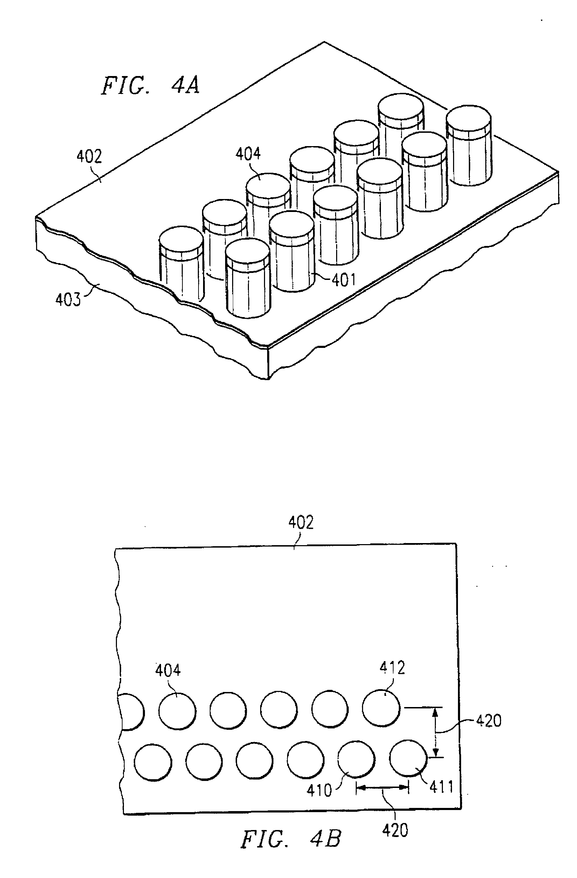

Another important characteristic of the interconnect structure of the present invention is the fine pitch center-to-center of the interconnecting columns. The perspective view of FIG. 4A schematically depicts two rows of interconnecting columns 401 attached to windows in the overcoat 402 on IC chip 403. Each column 401 has a cap 404 made of reflowable metal.

In top view, FIG. 4B shows the reflowable caps 404 so that the center-to-center distances can be measured. In the examples shown in FIG. 4B, the interconnections are arranged in "closest packing" configuration; the centers have an equidistant pitch. Between the interconnections 410, 411, and 412, the pitch is designated 420. The large aspect ratio of the columns, provided by the invention, enables a minimization of the pitch. The center-to-center spacing is less than 150 µm. For columns having a diameter of 50 µm and a height of 100 µm, the pitch is preferably less than 80 µm, for instance 75 µm.

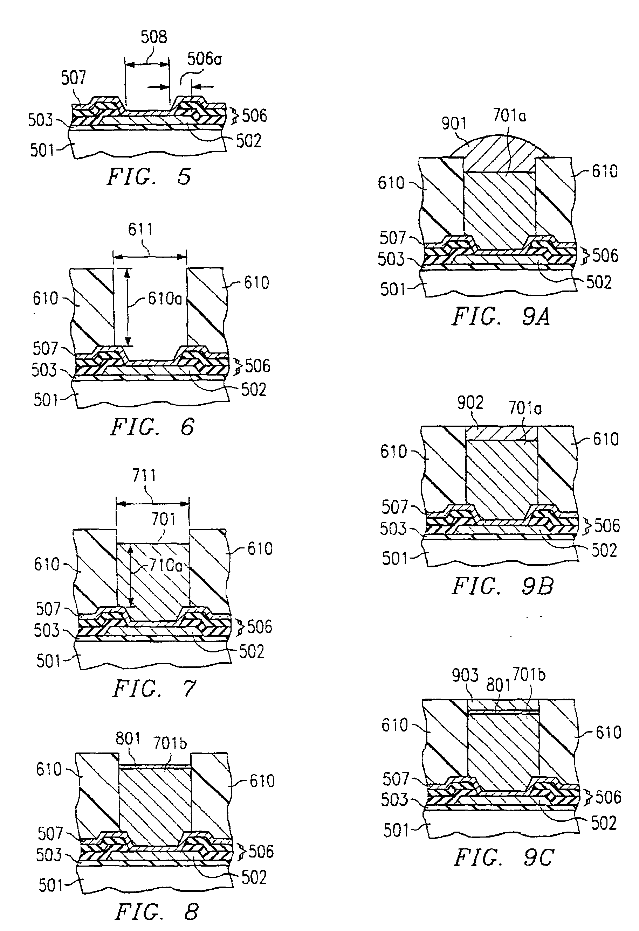

The schematic cross sections of FIGs. 5 through 11 illustrate the process flow for fabricating a high aspect ratio interconnect on a contact pad of an IC chip; the process flow is differentiated to demonstrate the creation of two embodiments of the invention, as well as a couple of variations. It should be stressed that the fabrication process is for a whole semiconductor wafer.

FIG. 5 shows a patterned layer 502 of the top metallization of IC wafer 501, located over insulating material 503 and protected by one or more overcoat layers 506. Patterned metallization 502 is preferably an aluminum alloy or copper. The overcoat 506 consists preferably of an inorganic, moisture-impermeable layer and an organic, stress-absorbing layer. Overcoat 506 overlaps the metallization 502 for a short, sloped length 506a. A window 508 has been opened in the overcoat 506, exposing the metallization 502. For purposes of electroplating, the "under-bump" metal layer 507 is deposited continuously over the whole wafer. If the metallization 502 is copper, layer 507 is preferably copper; if metallization 502 is aluminum, layer 507 contains refractory metals.

Especially in the case of a copper "under-bump" (UBM) layer 507 deposited on a patterned copper metallization 502, the exposed copper metallization 502 has to be carefully cleaned before depositing layer 507 by subjecting the wafer to the steps of:
- exposing the wafer to organic solvents, thereby removing organic contamination and mechanical particles from the metallization contact pads, and drying the wafer;
- exposing the wafer to an oxygen and nitrogen/argon/helium plasma, thereby ashing any organic residue on the metallization contact pads and oxidizing the metallization surface to a controlled thickness of less than 10 nm;
- without breaking the vacuum, exposing the wafer to a hydrogen and nitrogen/helium/argon plasma, thereby removing the controlled metallization oxide from the pad surface and passivating the cleaned surface; and
- sputter-etching the passivated pad surface with energetic ions, thereby creating a fresh surface and concurrently activating it.

In FIG. 6, a photoresist layer 610 has been applied over the whole semiconductor wafer. Preferably, the resist is a cresol Novalak resin, which typically contains propylene glycol monomethyl ether acetate (PGMEA). Suitable resists are, for example, commercially available from Clariant Corp., Somerville, NJ, USA, under the brand names AZ4620, PLP100, and AZ49xt. The thickness 610a of layer 610 is at least 50 % greater than overcoat window diameter 508 (in FIG. 5); a typical thickness is 100 µm. Dependent on the resist type, the layer thickness can be manufactured in a single or multi-coat application. A window 611 has been opened in resist 610 by exposing the resist to broadband or I-line light sources. The diameter of window 611 is related to the resist thickness 610a so that the intended electroplated column will obtain the desired height-to-width aspect ratio between 1.25 and 5.0, preferably between 2.0 and 4.0. In actual manufacturing, the column walls may not be exactly parallel to each other, but rather slightly inclined such that the column is somewhat wider on top than on the bottom interface with the IC contact pad.

Care should be taken to position photoresist window 611 so that it matches the position of the respective overcoat window 508. The overcoat window 508 is nested within the respective photoresist window 611 so that the photoresist window 611 has a diameter more than 5 % larger than the diameter of the overcoat window 508.

FIG. 7 illustrates the electroplated metal column 701 in the photoresist window. The preferred metal for column 701 is copper or a copper/nickel alloy. Obviously, the diameter 711 of column 701 is identical with the diameter 611 of the photoresist window, but the height 710a of the column should preferably be less than the photoresist thickness 610a in order to reserve some leftover height for plating the reflowable metal (see FIG. 9). Before the electroplating step of the column, the surface of under-bump layer 507 has to be carefully cleaned by exposing the wafer to a hydrogen and nitrogen/argon plasma, thereby cleaning and passivating the under-bump layer in the photoresist window. Without exposing the passivated under-bump layer 507 to fresh contamination, the metal column 701 is electroplated onto the exposed under-bump layer 507. Columns 701 which are made of wettable metal will now be designated 701a; columns 701 which are made of non-wettable metal, will now be designated 701b.

FIG. 8 depicts the second embodiment of the invention involving the process step, which has to be performed whenever a metal or metal alloy is chosen for column 701 which cannot be wetted by reflowable metal. Such metals for columns 701b include titanium, tantalum, tungsten, nickel vanadium, or alloys thereof. In this second embodiment of the invention, a layer 801 has to be electroplated to the top end of column 701b, which adheres to the metal of column 701b and is wettable on its outer surface. A preferred choice for layer 801 is nickel in the thickness range from about 15 to 20 µm; the outer surface may have a flash of palladium. Further, the interface layer 801 acts as a diffusion barrier for some of the metals of the column 701b.

FIGs. 9A, 9B, and 9C illustrate the process step of electroplating a cap of reflowable metal or metal alloy ("solder"). Such solders include tin, indium, tin alloys including tin/indium, tin/silver, tin bismuth, and tin/lead. The cap thickness can vary widely from about 1.0 to about 25.0 µm without overplating, and from 1.0 to 65 µm with overplating. So-called over-plating will result in a mushroom-shaped cap 901 as depicted in FIG. 9A. Just plating to the top of the photoresist thickness creates a layer 902 as depicted in FIG. 9B for the case of a wettable column 701a, or a layer 903 as depicted in FIG. 9C for the case of a wettable interface layer 801 on a non-wettable column 701b. By way of example for FIG. 9C, an overall photoresist window of 100 µm height could be filled with a 70µm high metal column 701b, followed by 15 µm interface layer 801, followed by 15 µm solder cap 903.

After removing the photoresist 610 and etching the under-bump metal (UBM) layer 507, the finished high aspect ratio interconnect is shown in FIG. 10A for the case of an overplated solder cap 901; in FIG. 10B for the case of a not overplated solder cap 902; and in FIG. 10C for the case of a not overplated solder cap 903 on an wettable interface layer 801. The interconnects shown in FIGs. 10A, 10B, and 10C are ready for assembly, which involves solder reflow.

FIGs. 11A, 11B, and 11C illustrate the effect of the additional process step of reflowing the solder at the solder melting temperature. In Figs. 11A and 11B, the plated column 701a is made of a wettable metal; consequently, the solders 901a and 902a are distributed over the whole column surface. In FIG. 11C, the plated column 701b is made of non-wettable metal; consequently, the solder remains as a cap 903a only on top of the barrier layer 801.

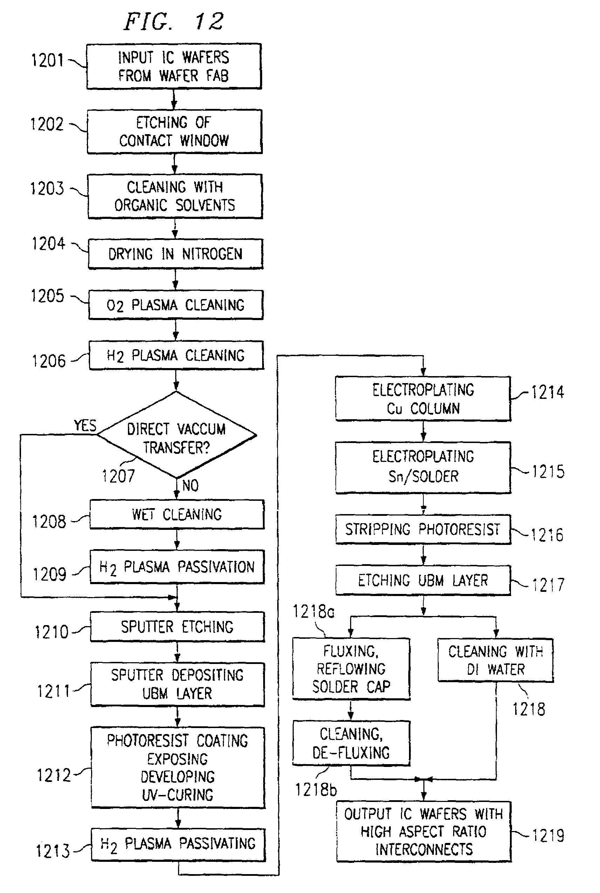

FIG. 12 shows a block diagram of the preferred wafer-level process flow for fabricating fine-pitch, high aspect ratio chip interconnects, first and second embodiments.
- Step 1201: Input: IC wafer from the wafer Fab. The wafer has copper interconnecting metallization.
- Step 1202: Etching the contact window: Etching the polymeric overcoat (for instance, benzocylobutene or polyimide) using a hot wet etch in basic developer (tetramethyl ammonium hydroxide) in order to open the window for the contact pad. The wet etch results in a relatively gentle slope of the overcoat around the window perimeter towards the copper of the pad.
   Etching the inorganic overcoat (for instance, silicon nitride or silicon oxynitride) using a fluoride-containing plasma in order to expose the copper pad of the IC metallization. At this stage, the pad still has an (uncontrolled) copper oxide surface; it may further be contaminated with organic residues (such as photoresist) and/or particulates.
- Step 1203: Exposing the wafer to organic solvents, thereby removing organic contamination and mechanical particles from the copper contact pads. Examples of suitable cleaning processes include:
   - submerging the wafer in agitated isopropyl alcohol, methanol, glycol, N-methyl pyrrolidone and other solvents;
   - adding ultrasonic/megasonic energy to these solvents;
   - spraying the wafer with an organic solvent;
   - treating the wafer in dry chemical vapor.
- Step 1204: Drying the wafer in dry nitrogen.
- Step 1205: Exposing the wafer to an oxygen and nitrogen/helium/argon plasma, thereby ashing any further organic residues on the copper contact pads and oxidizing the copper surface to a controlled thickness of less than 10 nm. Preferred plasma pressure between 0.1 and 10 Torr at 0.2 to 1.0 mol fraction oxygen and 0 to 0.8 mol fraction helium/argon; flow rate between 2.0 and 4.0 slpm. Temperature range is between 25 and 250 °C, time from 0.5 to 5 min.
- Step 1206: Without breaking the vacuum, exposing the wafer to a first hydrogen and nitrogen/helium/argon plasma, thereby removing the controlled copper oxide from the pad surface and passivating the cleaned surface. Preferred plasma pressure between 0.1 to 10 Torr at 0.2 to 1.0 mol fraction hydrogen, 0 to 0.8 mol fraction nitrogen, and 0 to 0.8 mol fraction helium/argon; flow rate between 2.0 and 4.0 slpm. Temperature range is between 25 and 250 °C, time from 0.5 to 5.0 min.
- Step 1207: Deciding whether to transfer the wafer directly to further processing under vacuum, or, alternately submit it to wet cleaning.
- Step 1208: Wet cleaning the wafer in order to remove the oxidized ("ashed") materials. Wet cleaning agents include, for example, dilute citric, acetic, or oxalic acids. Temperature range is between 25 and 80 °C, time from 0.5 to 15 min.
- Step 1209: Exposing the wafer to a hydrogen and nitrogen/argon plasma, thereby cleaning and passivating the copper layer in the photoresist window.
- Step 1210: Sputter-etching the passivated pad surface with energetic ions, thereby creating a fresh surface and concurrently activating it. Preferred plasma pressure between 5 and 100 mTorr at 750 to 1000 V bias. Temperature range is between 25 and 400 °C, time from 1.0 to 4.0 min.
- Step 1211: Sputter-depositing a UBM or copper layer, covering the fresh pad surface and pad perimeter, this layer providing minimal thermo-mechanical stress to the pad.
- Step 1212: Creating a window in thick photoresist cover:
   - coating the wafer with thick photoresist ;
   - exposing the window and masking the remainder;
   - developing the photoresist; and
   - ultra-violet (UV) curing the photoresist.
- Step 1213: Exposing the wafer to a hydrogen and nitrogen/argon plasma, thereby cleaning and passivating the UBM or copper layer in the photoresist window.
- Step 1214: Without exposing the UBM/passivated copper layer to fresh contamination, electroplating a copper column onto the exposed UBM/copper layer.
- Step 1215: Electroplating a tin/solder cap onto the copper column.
   When the column has been plated of a metal or alloy which cannot be wetted by tin/solder, a layer of metal (preferably nickel) has to be plated onto the column first, which adheres to the column metal and is wettable on its external surface.
- Step 1216: Stripping the photoresist.
- Step 1217: Etching the UBM/copper layer in order to electrically isolate the columns with caps from one another.
- Step 1218: Cleaning in DI water.
- Step 1219: Output: IC wafers with high aspect ratio interconnects (columns and solderable caps).
- Second embodiment:
   Step 1218a: Fluxing and reflowing solder cap.
   Step 1218b: Cleaning and de-fluxing.

While this invention has been described in reference to illustrative embodiments, this description is not intended to be construed in a limiting sense. Various modifications and combinations of the illustrative embodiments, as well as other embodiments of the invention, will be apparent to persons skilled in the art upon reference to the description. As an example, the invention can be applied to IC bond pad metallizations other than copper, which are difficult or impossible to contact by conventional tin or solder techniques, such as alloys of refractory metals and noble metals. As another example, the invention can be extended to batch processing, further reducing fabrication costs. As another example, the invention can be used in hybrid technologies of wire/ribbon bonding and solder interconnections. It is therefore intended that the appended claims encompass any such modifications or embodiments.

## Claims

1. A metal structure for an integrated circuit having a plurality of contact pads and a patterned metallization protected by an overcoat layer, comprising:
a plurality of windows in said overcoat, selectively exposing said metallization, said windows spaced apart by less than 150 µm center to center;
a metal column positioned on each of said windows, said column having a height-to-width aspect ratio larger than 1.25 and an upper surface wettable by re-flowable metal; and
a cap of a re-flowable metal positioned on each of said columns.

2. The structure according to Claim 1 further comprising a layer of metal on said exposed metallization.

3. The interconnect structure according to Claim 2 wherein said layer of metal is selected from a group consisting of titanium, tantalum, tungsten, nickel vanadium, and copper.

4. The interconnect structure according to any one of Claims 1 to 3 wherein said column is of a metal selected from a group consisting of copper, gold, silver, nickel, palladium, and alloys thereof.

5. The interconnect structure according to any one of Claims 1 to 4 wherein said column height-to-width aspect ratio is between 1.25 and 5.0.

6. The interconnect structure according to any one of Claims 1 to 4 wherein said column height-to-width aspect ratio is between 2.0 and 4.0.

7. A method for fabricating fine-pitch, high aspect ratio metal interconnects on integrated circuit contact pads suitable for assembly and interconnection with external parts, comprising the steps of:
providing an integrated circuit wafer having a patterned metallization protected by an overcoat layer;
opening a plurality of windows in said overcoat to selectively expose said metallization, said windows spaced apart by less than 150 µm center to center;
depositing a layer of first metal suitable to receive a plated coating;
depositing a photoresist layer having a thickness greater than said window diameter;
opening a plurality of windows in said photoresist to expose said first metal, each of said photoresist windows having a diameter larger than the diameter of said overcoat windows, the positions of said photoresist windows matching the positions of said overcoat windows respectively, each of said overcoat windows nested within its respective photoresist window; and
depositing a column of a second metal onto said first metal exposed in each of said photoresist windows, said column having a height-to-width aspect ratio larger than 1.25.

8. The method of Claim 7 wherein each window in said overcoat has a diameter of less than 80 µm.

9. The method of Claim 7 or 8 wherein each of said columns has an upper surface wettable by re-flowable metal and said method further comprises the step of depositing a cap of re-flowable metal on each of said columns.

10. The method of any one of Claims 7 to 9 further comprising the step of depositing a third metal at a top end of each of said columns, said third metal adhering to said top end and wettable on its outer surface.
